# EUROPÄISCHE PATENTSCHRIFT

(11) **EP 0 553 410 B1**
(45) Veröffentlichungstag und Bekanntmachung des Hinweises auf die Patenterteilung: **02.01.1997**
(21) Anmeldenummer: 92119074.0
(22) Anmeldetag: 06.11.1992
(51) Int. Cl.: C23C 14/35

(54) **Vorrichtung zum Beschichten eines Substrats, insbesondere mit elektrisch nichtleitenden Schichten**
Apparatus for coating a substrate, especially with nonconductive layers
Dispositif pour le revêtement d'un substrat, en particulier avec des couches non-électroconductrices

(30) Priorität: 29.01.1992 DE 4202425
(43) Veröffentlichungstag der Anmeldung: 04.08.1993
(73) Patentinhaber: Balzers und Leybold Deutschland Holding Aktiengesellschaft, 63450 Hanau (DE)
(72) Erfinder: Szczyrbowski, Joachim, Dr., W-8758 Goldbach (DE); Teschner, Götz, Dipl.-Ing., W-6460 Gelnhausen (DE); Beisswenger, Siegfried, Dr., W-8755 Alzenau (DE)

(56) Entgegenhaltungen:
- EP-A- 0 416 241
- DE-A- 3 919 147
- DE-A- 4 010 495
- J. Harpold, "How Advanced Energy MDX Products Manage Arcs", Advanced Energy Industries Inc., US, 1993
- GLOW DISCHARGE PROCESSES, J. Wiley & Sons, Inc. New York USA 1980; B. Chapman: Pages 143-145

## Beschreibung

Die Erfindung betrifft eine Vorrichtung zum Beschichten eines Substrats, insbesondere mit elektrisch nichtleitenden Schichten, von einem elektrisch leitfähigen Target in reaktiver (z. B. oxidierender) Atmosphäre, bestehend aus einer in einer evakuierbaren Beschichtungskammer angeordneten, einen Magneten einschließenden Kathode die elektrisch mit einem Target zusammenwirkt, das zerstäubt wird und deren abgestäubte Teilchen sich auf dem Substrat niederschlagen, wobei die Kathode an eine Gleichstromquelle oder an eine Wechselstromquelle angeschlossen ist. Zwischen Gleichstrom und Wechselstrom kann geschaltet werden. Eine solche Vorrichtung ist aus EP-A-0 416 241 bekannt.

Es ist bereits eine Vorrichtung zum reaktiven Beschichten eines Substrats in einer älteren, nicht vorveröffentlichten Patentanmeldung beschrieben (DE-A-41 36 655; Zusatz zu DE-A-40 42 289), bei der eine elektrisch von der Vakuumkammer getrennte, als Magnetronkathode ausgebildete, aus zwei elektrisch voneinander getrennten Teilen bestehende Kathode, bei der der Targetgrundkörper mit Joch und Magneten als der eine Teil - unter Zwischenschaltung einer Kapazität - an den negativen Pol einer Gleichstrom-Spannungsversorgung und das Target als der andere Teil über eine Leitung und unter Zwischenschaltung einer Drossel und einem dieser parallel liegenden Widerstand an die Stromversorgung angeschlossen ist und wobei das Target über eine weitere Kapazität mit dem Pluspol der Stromversorgung und mit der Anode verbunden ist, die ihrerseits - unter Zwischenschaltung eines Widerstandes - auf Masse liegt, wobei in Reihe zur induktionsarmen Kapazität eine Induktivität in die Zweigleitung zum Widerstand und zur Drossel eingeschaltet ist und der Wert für den Widerstand typischerweise zwischen 2 KΩ und 10 KΩ liegt.

Diese ältere Vorrichtung ist bereits so ausgebildet, daß sie die überwiegende Zahl der während eines Beschichtungsprozesses auftretenden Arcs unterdrückt, die Energie der Arcs absenkt und die Wiederzündung des Plasmas nach einem Arc verbessert.

In einer weiteren älteren Patentanmeldung (DE-A-41 27 504) wurde auch bereits eine Schaltungsanordnung zum Löschen von Lichtbögen in Plasmavorrichtungen geschaffen, um auch beim Sputtern von schwierigen Materialien, z. B. von SiO₂, hohe Beschichtungsraten zu ermöglichen. Es wird dabei der Augenblickswert der Spannung der Plasmastrecke mit einem Spannungswert verglichen, der einer über eine vorgegebene Zeit ermittelten mittleren Plasmaspannung entspricht, wobei dann, wenn die Differenz zwischen dem Augenblickswert der Plasmaspannung einen vorgegebenen Wert übersteigt, die Plasmastrecke von der Spannungsquelle getrennt wird.

Bei der aus EP-A-0 416 241 bekannten Vorrichtung bildet das Substrat selbst die Anode. Bei dieser Vorrichtung ist durch die HF-Versorgung das Verhältnis Pausenzeit : Sputterzeit fest vorgegeben, da der Spannungsverlauf stets sinusförmig ist. Dabei muß die Hochfrequenz so bestimmt werden, daß die Beweglichkeitsdifferenz zwischen Ionen und Elektronen das Verfahren bestimmt. HF-Versorgung mit zusätzlichem Bias ist auch bei der bekannten Vorrichtung möglich.

Beim reaktiven Sputtern von Metalloxiden bzw. Metallnitriden kann die Entstehung von mehr oder weniger gut isolierenden Schichten auf der Targetoberfläche nicht vermieden werden. Solche Isolierschichten auf dem Target stehen in Plasmakontakt und laden sich deshalb elektrisch auf. Aufgrund der hohen elektrischen Feldstärke in diesen dünnen Schichten kann es zu elektrischen Durchbrüchen kommen. Auf diese Weise wird ein Arc initialisiert. Die Folgen sind eine punktuelle Zerstörung des Targets und damit Schichtdefekte auf dem Substrat.

Beim Mittelfrequenzsputtern (wie es beispielsweise in den älteren deutschen Patentanmeldungen DE-A-41 38 793 und DE-A-41 38 794 beschrieben ist) hat sich nun gezeigt, daß spontane Arcs mit weit geringerer Häufigkeit auftreten als beim normalen DC-Sputtern. Die Besonderheit des bekannten Verfahrens ist, daß die Kathoden im Takt der Mittelfrequenz periodisch umgeladen werden.

Ausgehend von den Erfahrungen mit Vorrichtungen zum Mittelfrequenzsputtern liegt der vorliegenden Erfindung die Aufgabe zugrunde, eine Vorrichtung des in Frage stehenden Typs so zu verbessern, daß auch bei der Beschichtung von sehr großen Substraten die aufgesputterten Schichten in ihrer Qualität bzw. Fehlerfreiheit weiter verbessert werden, was insbesondere die höchstmögliche Unterdrückung von Arcs erfordert.

Diese Aufgabe wird erfindungsgemäß dadurch gelöst, daß die Frequenz des Umpolens einstellbar ist und die zusätzliche Schaltung einer Thyristor-Brücke mit vier Thyristoren und einem Kondensator gebildet ist, wobei die Stromquelle mit einem Pol mit den Kathoden des ersten Thyristorpaares und mit ihrem anderen Pol mit den Anoden des zweiten Thyristorpaares verbunden ist und die Kathoden des ersten Thyristorpaares außerdem mit der Sputterkathode und die Anoden des zweiten Thyristorpaares mit der Anode verbunden sind. Die Anode ist elektrisch von der Sputterkammer getrennt.

Mit Vorteil sind die Steuerelektroden der Thyristoren jeweils paarweise über Paare von Ansteuerverstärkern mit Impulsformern und über diese mit einem Flipflop-Element verbunden, das seinerseits über eine Logikschaltung sowohl mit einem Arc-Detektor als auch mit einem Impulsgenerator in Wirkverbindung steht.

Die Erfindung läßt die verschiedensten Ausführungsmöglichkeiten zu; eine davon ist in den anhängenden Zeichnungen rein schematisch näher dargestellt, und zwar zeigen:
- Fig. 1: die sehr stark vereinfachte elektrische Schaltung für eine Vorrichtung des in Frage stehenden Typs,
- Fig. 2: das Ersatzschaltbild zur Schaltung nach Fig. 1,
- Fig. 3: die diagrammatische Darstellung der periodischen Umpolung der Kathodenspannung über der Zeitachse,
- Fig. 4: der vervollständigte Stromlaufplan der Schaltung zur Vorrichtung nach der Erfindung.

Das Umpolen der Kathode einer Sputtervorrichtung wird dadurch erreicht, daß über eine Thyristor-Brückenschaltung ein positiv aufgeladener Kondensator parallel zur Entladungsstrecke des DC-Magnetrons geschaltet wird.

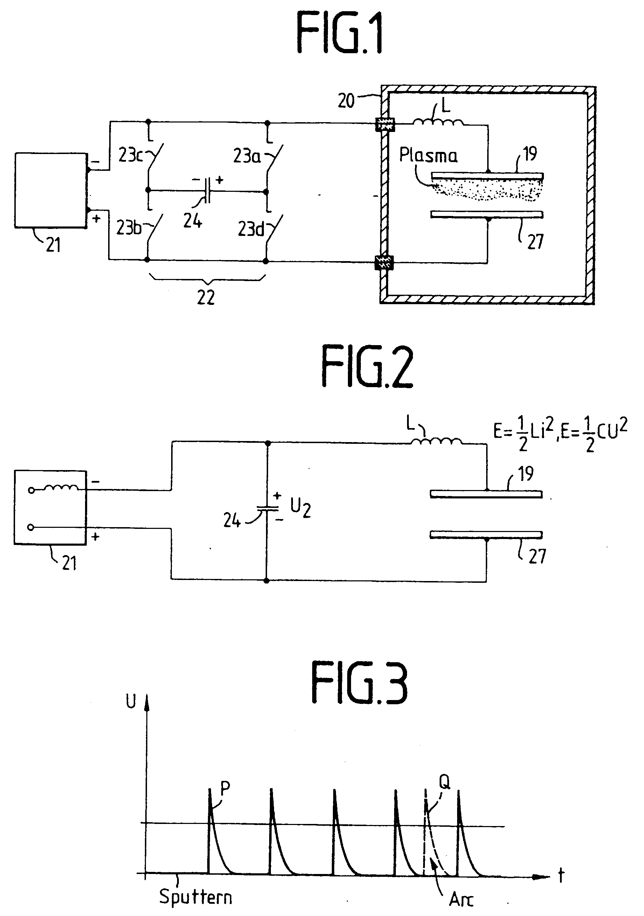

Figur 1 zeigt stark vereinfacht eine in einer Vakuumkammer 20 angeordnete Magnetronkathode 19, die an eine Gleichstromquelle 21 angeschlossen ist. Zwischen der Vakuumkammer 20 und der Stromquelle 21 ist eine Brükkenschaltung 22 mittels vier Schaltern 23a, 23b, 23c, 23d symbolisiert.

Werden zum Beispiel die Schalter 23a und 23b geschlossen, so ergibt sich dynamisch die in Figur 2 dargestellte Situation (Ersatzschaltbild zu Figur 1). Da bisher über die Eigeninduktivität L der Kathode 19 der Entladestrom geflossen ist, entsteht die Induktionsspannung U₁, die der Spannung U2 des Kondensators 24 entgegengerichtet ist. U₁ ist größer als U₂, da die Eigeninduktivität im ersten Augenblick genau die Spannung bereitstellt, die den zuvor geflossenen Strom aufrecht erhalten kann. Ist die in der Induktivität gespeicherte Energie 1/2 LI² aufgebraucht und der Kondensator 24 noch nicht entladen, dann liegt eine positive Restspannung an der Kathode 19 an (Dimensionierungsbedingungen deshalb: 1/2 LI² < 1/2 CU²). Zu diesem Zeitpunkt ist die Entladung an der Kathode (Sputtermagnetron) 19 bereits erloschen. Nun gewinnt die weitere Entladung und umgekehrte Aufladung des Kondensators 24 durch die Gleichspannungsquelle 21 die Oberhand. Auf diese Weise wird der Kondensator 24 voll negativ aufgeladen.

Gleichzeitig erreicht die Spannung an der Kathode 19 denselben negativen Wert. Der Sputterprozeß wird demzufolge fortgesetzt. Der umgekehrt aufgeladene Kondensator 24 steht für einen nächsten Umpolzyklus bereit. Dieses Mal wird der Prozeß durch Schließen der Schalter 23 c und 23d in Gang gesetzt.

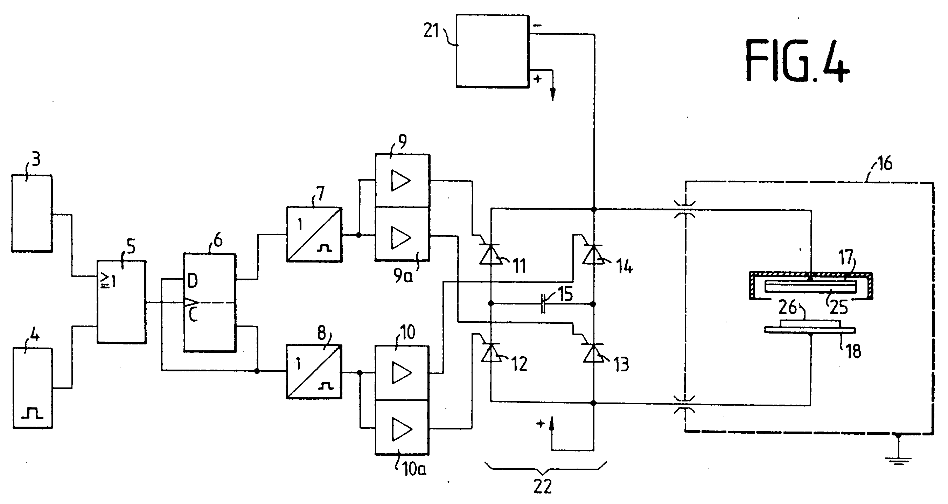

Dieser periodische Prozeß wird erreicht, indem (siehe Figur 4) mittels eines Impulsgenerators 4 und entsprechender bekannter elektronischer Schaltungen die Schalter 23a bis 23d in sinnfälliger Weise betätigt werden.

Der Umpolprozeß kann aber auch durch einen sogenannten "spontanen Arc" ausgelöst werden. Hier übernimmt eine Arc-Detektionsschaltung, wie sie beispielsweise in der älteren deutschen Patentanmeldung DE-A-41 27 504 näher beschrieben ist, die Funktion der Auslösung der Brükkenschaltung 22. Dabei werden der Arc-Detektor und der Impulsgenerator (logisch) parallel geschaltet.

Der in Figur 3 dargestellte zeitliche Spannungsverlauf an der Kathode 19 zeigt diagrammatisch das periodische Umpolen in Form der Kurve P und den spontan auftretenden Arc in der strichliert eingezeichneten Kurve Q, wobei U wiederum die Kathodenspannung darstellt.

Der Stromlaufplan gemäß Figur 4 zeigt im wesentlichen einen Arc-Detektor 3, einen Impulsgenerator 4, eine mit diesen beiden Schaltelementen verbundene Logikschaltung (OR-Glied) 5, einen dieser Logikschaltung 5 nachgeschalteten Flipflop 6, die beiden dem Flipflop 6 nachgeschalteten Impulsformer 7, 8, die diesen nachgeschalteten Ansteuerverstärkern 9, 9a, 10, 10a, die aus den Thyristoren 11 bis 14 und dem Kondenstor 15 bestehenden Brückenschaltung 22 und die in der Vakuumkammer 16 vorgesehenen Kathoden-Anoden-Anordnung 17, 18.

Die in Figur 4 dargestellte Halbleiterbrücke 22 ist aus vier Thyristoren 11, 12, 13, 14 und einem Kondensator 15 aufgebaut und zeigt damit ein praktisches Ausführungsbeispiel für die in Figur 1 rein prinzipiell dargestellte Schaltung. Der Impulsgenerator 4 erzeugt Impulse mit einer Dauer von etwa 5µs und einer Wiederholfrequenz von 1 Hz bis etwa 1 kHz.

Es sei noch erwähnt, daß Teil der Kathode 17 das Target 25 ist, daß sich auf der Anode das Substrat 26 befindet und daß die Stromversorgung 21 an die Brückenschaltung 22 angeschlossen ist (das Substrat 26 kann auch floatend angeordnet sein, d. h. sich zwischen den Teilen 17 und 18 befinden).

Der in Figur 4 schematisch dargestellte Arc-Detektor 3 stellt eine Schaltungsanordnung dar, bei der der Augenblickswert der Spannung der Plasmastrecke mit einem Spannungswert verglichen wird, der einer über eine vorgegebene Zeit ermittelten mittleren Plasmaspannung entspricht, wobei dann, wenn die Differenz zwischen dem Augenblickswert, der Plasmaspannung und der mittleren Plasmaspannung einen vorgegebenen Wert übersteigt, die Plasmastrecke von der Spannungsquelle getrennt wird.

### Bezugszeichenliste

- 3: Arc-Detektor
- 4: Impulsgenerator
- 5: Logikschaltung, OR-Glied
- 6: Flipflop
- 7: Impulsformer
- 8: Impulsformer
- 9, 9a: Ansteuerverstärker
- 10, 10a: Ansteuerverstärker
- 11: Thyristor
- 12: Thyristor
- 13: Thyristor
- 14: Thyristor
- 15: Kondensator
- 16: Vakuumkammer
- 17: Kathode
- 18: Anode
- 19: Magnetronkathode
- 20: Vakuumkammer
- 21: Gleichstromquelle
- 22: Schalteranordnung, Brückenschaltung
- 23a, 23b: Schalter
- 23c, 23d: Schalter
- 24: Kondensator
- 25: Target
- 26: Substrat
- 27: Anode

## Patentansprüche

1. Vorrichtung zum Beschichten eines Substrats (26) insbesondere mit elektrisch nichtleitenden Schichten, von einem elektrisch leitfähigen Target (25) in reaktiver Atmosphäre, bestehend aus einer Gleichstromquelle (21), die mit einer in einer evakuierbaren Beschichtungskammer (16 bzw. 20) angeordneten, einen Magneten einschließende Kathode (17 bzw. 19) verbunden ist, die elektrisch mit einem Target (25) zusammenwirkt, das zerstäubt wird und deren abgestäubte Teilchen sich auf dem Substrat (26) niederschlagen, wobei die Kathode (17 bzw. 19) an die Gleichstromquelle (21) angeschlossen ist und mit Hilfe einer angepaßten zusätzlichen Schaltung (22) periodisch für kurze Zeitspanne auf ein positives Potential schaltbar ist, gekennzeichnet dadurch, daß eine elektrisch von der Sputterkammer (16 bzw. 20) getrennte Anode (18) vorgesehen ist, die Frequenz des Umpolens einstellbar ist und die zusätzliche Schaltung (22) aus einer Thyristor-Brücke mit vier Thyristoren (11 bis 14) und einem Kondensator gebildet ist, wobei die Stromquelle (21) mit einem Pol mit den Kathoden des ersten Thyristorpaares (11,14) und mit ihrem anderen Pol mit den Anoden des zweiten Thyristorpaares (12,13) verbunden ist und die Kathoden (11,14) des ersten Thyristorpaares (11,14) außerdem mit der Sputterkathode (17) und die Anoden des zweiten Thyristorpaares (12,13) mit der Anode (18) verbunden sind.

2. Vorrichtung nach Anspruch 1, **dadurch gekennzeichnet**, daß die Steuerelektroden der Thyristoren (11 bis 14) jeweils paarweise über Paare von Ansteuerverstärkern (9,9a bzw. 10,10a) mit Impulsformern (7,8) und über diese mit einem Flipflop-Element (6) verbunden sind, das seinerseits über eine Logikschaltung (5) sowohl mit einem Arc-Detektor als auch einem Impulsgenerator (4) in Wirkverbindung steht.

## Claims

1. Apparatus for coating a substrate (26), in particular with electrically non-conductive layers, from an electrically conductive target (25) in a reactive atmosphere consisting of a direct-current source (21) connected to a cathode (17 or 19) which is arranged in an evacuable coating chamber (16 or 20), encloses a magnet and cooperates electrically with a target (25) which is atomised and of which the atomised particles settle on the substrate (26), wherein the cathode (17 or 19) is connected to the direct-current source (21) and is switchable to a positive potential periodically for a short period of time by means of an adapted additional circuit (22), characterised in that an anode (18) which is electrically separated from the sputter chamber (16 or 20) is provided, the frequency of polarity reversal is adjustable and the additional circuit (22) is formed from a thyristor bridge with four thyristors (11 to 14) and a capacitor, wherein the current source (21) is connected with one pole to the cathodes of the first thyristor pair (11,14) and with its other pole to the anodes of the second thyristor pair (12,13) and the cathodes (11,14) of the first thyristor pair (11,14) are also connected to the sputter cathode (17) and the anodes of the second thyristor pair (12,13) to the anode (18).

2. Apparatus according to claim 1, characterised in that the control electrodes of the thyristors (11 to 14) are each connected in pairs via pairs of control amplifiers (9,9a or 10,10a) with pulse shapers (7,8) and via them with a flipflop element (6) which, in turn, cooperates via a logic circuit (5) with both an arc detector and a pulse generator (4).

## Revendications

1. Dispositif de revêtement d'un substrat (26) en particulier de couches électriquement non conductrices, depuis une cible électriquement conductrice (25) dans une atmosphère réactive, se composant d'une source de courant continu (21), qui est reliée à une cathode (17, 19, respectivement) comprenant un aimant, disposé dans une chambre de revêtement vidée (16, 20, respectivement), qui coopère électriquement avec une cible (25) qui est pulvérisée et dont les particules pulvérisées se déposent sur le substrat (26), la cathode (17, 19, respectivement) étant reliée à la source de courant continue (25) et peut être portée à un potentiel positif périodiquement pendant de courts instants à l'aide d'un circuit supplémentaire adapté (22), caractérisé en ce qu'une anode (18) séparée électriquement de la chambre de pulvérisation (16, 20, respectivement) est prévue, la fréquence de l'inversion de pôle étant réglable et le circuit supplémentaire (22) étant formé d'un pont à thyristors comportant quatre thyristors (11 à 14) et d'un condensateur, la source de courant (21) étant reliée par un pôle aux cathodes de la première paire de thyristors (11, 14) et par son autre pôle aux anodes de la seconde paire de thyristors (12, 13) et les cathodes (11, 14) de la première paire de thyristors (11, 14) étant en outre reliées à la cathode de pulvérisation (17) et les anodes de la seconde paire de thyristors (12, 13) à l'anode (18).

2. Dispositif selon la revendication 2, caractérisé en ce que les électrodes de commande des thyristors (11 à 14) sont reliées par paire par l'intermédiaire de paires d'amplificateurs de commande (9, 9a, 10, 10a, respectivement) à des conformateurs d'impulsions (7, 8) et par l'intermédiaire de ceux-ci à une bascule (6), qui pour sa part, est reliée fonctionnellement par l'intermédiaire d'un circuit logique (5) ainsi qu'avec un détecteur d'arc en tant également que générateur d'impulsion (4).
